# EUROPÄISCHE PATENTSCHRIFT

(11) **EP 2 300 631 B1**
(45) Veröffentlichungstag und Bekanntmachung des Hinweises auf die Patenterteilung: **12.03.2014**
(21) Anmeldenummer: 09761451.5
(22) Anmeldetag: 09.06.2009
(51) Int. Cl.: C23C 14/35, C23C 14/08, C23C 14/58

(54) **VERFAHREN ZUR HERSTELLUNG EINER TRANSPARENTEN UND LEITFÄHIGEN METALLOXIDSCHICHT DURCH GEPULSTES, HOCHIONISIERENDES MAGNETRONSPUTTERN**
METHOD FOR PRODUCING A TRANSPARENT AND CONDUCTIVE METAL OXIDE LAYER BY HIGHLY IONIZED PULSED MAGNETRON SPUTTERING
PROCÉDÉ POUR PRODUIRE UNE COUCHE D'OXYDE MÉTALLIQUE TRANSPARENTE ET CONDUCTRICE PAR PULVÉRISATION MAGNÉTRON PULSÉE HAUTEMENT IONISANTE

(30) Priorität: 13.06.2008 DE 102008028140
(43) Veröffentlichungstag der Anmeldung: 30.03.2011
(73) Patentinhaber: Fraunhofer-Gesellschaft zur Förderung der angewandten Forschung e.V., 80686 München (DE)
(72) Erfinder: HORSTMANN, Felix, 38118 Braunschweig (DE); SITTINGER, Felix, 38106 Braunschweig (DE); SZYZSKA, Bernd, 38108 Braunschweig (DE)
(86) Internationale Anmeldenummer: PCT/EP2009/004115
(87) Internationale Veröffentlichungsnummer: WO 2009/149888

(56) Entgegenhaltungen:
- EP-A- 1 731 629
- EP-A- 1 936 008
- DE-A1-102006 021 994
- DE-A1-102006 046 312
- SITTINGER V ET AL: "High power pulsed magnetron sputtering of transparent conducting oxides" THIN SOLID FILMS, ELSEVIER-SEQUOIA S.A. LAUSANNE, CH, [Online] Bd. 516, Nr. 17, 16. Oktober 2007 (2007-10-16), Seiten 5847-5859, XP022688406 ISSN: 0040-6090 Gefunden im Internet: URL:doi:10.1016/j.tsf.2007.10.031>
- ANDERS A., ANDERSSON J. AND ARUTIUN E.: "High power impulse magnetron sputtering: Current-voltage-time characteristics indicate the onset of sustained self-sputtering" JOURNAL OF APPLIED PHYSICS, AMERICAN INSTITUTE OF PHYSICS. NEW YORK, US, Bd. 102, Nr. 11, 4. Dezember 2007 (2007-12-04), Seiten 113303-1-113303-11, XP012105040 ISSN: 0021-8979 in der Anmeldung erwähnt

## Beschreibung

Die vorliegende Erfindung bezieht sich auf ein Verfahren zur Herstellung einer transparenten und leitfähigen Metalloxidschicht auf einem Substrat, bei dem zumindest ein Bestandteil der Metalloxidschicht durch gepulstes, hochionisierendes Magnetronsputtern zerstäubt wird und auf dem Substrat kondensiert.

Mit Hilfe physikalischer Gasphasenabscheideverfahren (engl.: PVD, Physial Vapour Deposition), die aus dem Stand der Technik in zahlreichen unterschiedlichen Verfahrensvarianten bereits bekannt sind, kann ein Substrat mit einer Metalloxidschicht beschichtet werden, die zum Beispiel transparent und leitfähig sein kann. Dabei wird mindestens ein Bestandteil des Schichtmaterials, mit dem eine Oberfläche des Substrats beschichtet werden soll, verdampft und kondensiert anschließend auf der zu beschichtenden Oberfläche.

Eine wichtige Gruppe der vorstehend genannten physikalischen Gasphasenabscheideverfahren bilden die so genannten Sputterverfahren, bei denen das Schichtmaterial in Form eines Festkörper-Targets vorliegt, welches durch einen Ionenbeschuss zerstäubt wird und dabei in die Gasphase überführt wird. Ein häufig eingesetztes Verfahren zum Erzeugen einer Metalloxidschicht auf einem Substrat ist das so genannte Magnetronsputtern, das in den vergangenen Jahren einige Weiterentwicklungen erfahren hat. So stellt zum Beispiel das so genannte gepulste HochleistungsMagnetronsputtern (HPPMS) ein neuartiges Verfahren dar, um Schichten beziehungsweise Schichtsysteme mit neuartigen mechanischen und chemischen Eigenschaften herzustellen. Bei einem derartigen Verfahren wird das Plasma beispielsweise durch periodisches Entladen einer Kondensatorbank aufgebaut (siehe zum Beispiel Christie D.J.: Journal of Vacuum Science and Technology A 23 (2005), S. 330-5). Es handelt sich um ein gepulstes Sputterverfahren, bei dem die Leistungsdichte am Target etwa das 30- bis 100-fache der bei herkömmlichen (DC-) Magnetronsputterverfahren üblichen Werte erreichen kann. Für metallische Sputterprozesse sind Peakleistungsdichten möglich, die größer als 1 kW/cm² sind (siehe Anders A., Andersson J., Ehiasarian A., Journal of Applied Physics 102, 113303 (2007)). Unter derartigen Prozessbedingungen wird die Magnetron-Entladung im Übergang zur Bogenentladung betrieben. Hierdurch kommt es zu einer erhöhten Ionisation des gesputterten Targetmaterials.

Das vorstehend kurz erläuterte HPPMS-Verfahren zeichnet sich im Vergleich zu herkömmlichen DC-Sputterverfahren insbesondere durch einen hohen Ionisationsgrad sowie durch eine erhöhte kinetische Energie des schichtbildenden Teilchenstroms beim Auftreffen auf die Oberfläche des zu beschichtenden Substrats aus. Dadurch wird zum einen die Beweglichkeit der adsorbierten Teilchen auf der Oberfläche des Substrats erhöht und zum anderen werden die Energieeinträge durch die zusätzlichen reflektierten Neutralteilchen und durch am Target gebildete negative Sauerstoffionen, die gleichfalls auf die Schicht auftreffen, ebenfalls stark erhöht. Für das Sputtern von Metallen wurden bereits Ionisationsgrade von mehr als 80 % gegenüber Werten von weniger als 1 % für den konventionellen kontinuierlichen Betrieb erreicht. Beim Sputtern keramischer Festkörper-Targets beziehungsweise metallischer Festkörper-Targets im Reaktivgasprozess konnten bislang jedoch nur relativ geringe Leistungsdichten bis maximal 1.5 kW/cm² erreicht werden (siehe V. Sittinger, F. Ruske, W. Werner, C. Gerloff, B. Szyszka, D.J. Christie: SVC Annual Technical Conference Proceedings 49 (2006) 343: V. Sittinger, F. Ruske, B. Szyszka, D.J. Christie, T. Wallendorf.: SVC Annual Technical Conference Proceedings 50 (2007)).

Aus dem Stand der Technik sind bereits MPPMS-Verfahren zur Abscheidung von Metalloxidschichten mit Peakleistungsdichten größer als 1,5 kW/cm² und Pulsen mit Zeitdauern ≤ 200 µs bekannt (siehe: Anders et al.: J. Appl. Phys., Vol. 102 (1997), S. 113303; Sproul et al.: Thin Solid Films, Vol. 491 (2005), S. 1 - 17 und DE 10 2006 021 994 A1). Aus der erstgenannten Publikation ist es ferner bereits bekannt, dass je nach Targetmaterial und angelegter Spannung beim Zünden des Plasmas hohe Stromflussdichten auftreten können. Diese Publikation belegt ferner die im Stand der Technik übliche Vorgehensweise, die entstehenden Ströme durch das so genannte "Arc-Handling" (Bogenentladungshandling) zu begrenzen.

Ein weiteres Verfahren zur Herstellung einer transparenten und leitfähigen Metalloxidschicht auf einem Substrat, bei dem zumindest ein Bestandteil der Metalloxidschicht durch hochionisierendes, gepulstes Hochleistungsmagnetronsputtern zerstäubt wird, wird in V. Sittinger et al. "High power pulsed magnetron sputtering of transparent conducting oxides" (in: "Thin Solid Films", Band 516 (2008), S. 5847 bis 5859) beschrieben. Die Pulse haben Pulsdauern, die kleiner als 200 µs sind, und weisen eine Peakleistungsdichte von bis zu 1,5 kW/cm² auf.

Ein Nachteil der mit den aus dem Stand der Technik bekannten Verfahren hergestellten transparenten und leitfähigen Metalloxidschichten besteht darin, dass sie für zahlreiche praktische Anwendungen keine ausreichende mechanische beziehungsweise chemische Stabilität und keine zufriedenstellenden optischen Eigenschaften aufweisen.

Der vorliegenden Erfindung liegt die Aufgabe zugrunde, ein Verfahren zur Herstellung einer transparenten und leitfähigen Metalloxidschicht auf einem Substrat durch hochionisierendes, gepulstes Hochleistungsmagnetronsputtern zur Verfügung zu stellen, mittels dessen besonders vorteilhafte Schichteigenschaften der Metalloxidschicht - insbesondere im Hinblick auf deren mechanische und chemische Stabilität - erhalten werden können.

Diese Aufgabe wird durch ein Verfahren der eingangs genannten Art mit den Merkmalen des kennzeichnenden Teils des Anspruchs 1 gelöst. Die Unteransprüche betreffen vorteilhafte Weiterbildungen der Erfindung.

Ein erfindungsgemäßes Verfahren zur Herstellung einer Metalloxidschicht (beziehungsweise eines Metalloxidschichtsystems) auf einem Substrat durch hochionisierendes, gepulstes Hochleistungsmagnetronsputtern zeichnet sich dadurch aus, dass
- die Pulse des Magnetrons eine Peakleistungsdichte aufweisen, die größer als 1,5 kW/cm² ist,
- die Pulse des Magnetrons eine Zeitdauer haben, die ≤ 200 µs ist, sowie
- der mittlere Stromflussdichteanstieg beim Zünden des Plasmas innerhalb eines Zeitintervall, das ≤ 0.025 ms ist, mindestens 106 A/(ms cm²) beträgt.

Zur Durchführung des Verfahrens wird ein Magnetron im Pulsbetrieb eingesetzt, wobei die Pulse eine bestimmte Pulsdauer haben und der mittlere Stromanstieg beim Zünden des Plasmas mindestens 106 A/(ms cm²) beträgt. Dabei wird ein Zeitintervall von 0.025 ms nicht überschritten. Die Peakleistungsdichte muss dabei - bezogen auf die gesputterte Fläche des Targets - größer als 1,5 kW/cm² sein. Die Substrate, die mit der transparenten und leitfähigen Metalloxidschicht beschichtet werden, können insbesondere aus Glas, Kunststoff, Metall oder Keramik bestehen. Beispielsweise kann die transparente und leitfähige Metalloxidschicht eine Indiumzinnoxidschicht sein, die auf ein Glassubstrat aufgebracht wird, um dadurch ein Glasprodukt mit einer niedrig emittierenden Oberfläche zu erhalten, die zum Beispiel zur Herstellung einer Außenverglasung eines Kraftfahrzeugs eingesetzt werden kann. Gegenüber den aus dem Stand der Technik bekannten Verfahren werden bei dem erfindungsgemäßen Verfahren Peakleistungsdichten erzeugt, die pro Puls größer als 1,5 kW/cm² sind, und zwar bei vergleichbarerer beziehungsweise nochmals verkürzter Pulsdauer in einer Größenordnung von etwa 200 µs und darunter. Es hat sich gezeigt, dass die Eigenschaften der Metalloxidschichten für unterschiedliche Applikationen insbesondere durch den steileren Stromanstieg entscheidend optimiert werden können. Es hat sich gezeigt, dass die Puls- und Leistungsparameter entscheidend sind, um eine Schichtstruktur mit besonders vorteilhaften mechanischen und chemischen Eigenschaften zu erzeugen. So können die Morphologie und Textur der Metalloxidschicht und die daraus resultierenden Schichteigenschaften durch eine gezielte Anpassung/Veränderung der Generatorparameter extrem beeinflusst werden.

Im Vergleich zu herkömmlichen, aus dem Stand der Technik bekannten DC-Magnetronsputterverfahren und den bisher verwendeten ionisierenden Verfahren führt das erfindungsgemäße Verfahren zu einer erhöhten kinetischen Energie sowie zu einem höheren Ionisationsgrad der zur Schichtbildung auf der Substratoberfläche beitragenden Spezies, die entscheidend sind, um zum Beispiel nach einem sich an das Aufbringen der Schicht anschließenden Einscheibensicherheitsglas- beziehungsweise Verbund-Sicherheitsglasprozess (kurz: ESG-Prozess beziehungsweise VSG-Prozess) eine mechanisch stabile Metalloxidschicht auf einem Glassubstrat zu erhalten. Durch die mit dem erfindungsgemäßen Verfahren einstellbare Textur und Morphologie kann die Metalloxidschicht die im anschließend durchgeführten Temperschritt (ESG/VSG-Prozess) benötigten Eigenschaften erreichen sowie einen Biegeprozess ohne Beschädigung überstehen.

Es besteht in besonders vorteilhafter Weise die Möglichkeit, dass auf jegliche Art der Bogenentladungsdetektion beziehungsweise des Bogenentladungshandlings verzichtet werden kann. Bei den bisherigen Generatortypen, die bei den HPPMS-Verfahren eingesetzt wurden, ist aufgrund der Überlastung der Komponenten ein so genanntes "Arc-Handling" (Bogenentladungshandling) vorgesehen, welches beispielsweise den Stromanstieg durch einen Schwellwertschalter begrenzt. Bei dem hier vorgestellten Verfahren ist dieses nicht mehr notwendig, da durch die Vorgabe der Länge der Pulsdauer ein Abschalten des Generators automatisch erfolgen kann. Dies erlaubt in besonders vorteilhafter Weise den Einsatz von deutlich günstigeren Generatoren als bislang.

Es kann in einer besonders bevorzugten Ausführungsform vorgesehen sein, dass die Pulse des Magnetrons eine Peakleistungsdichte aufweisen, die mindestens 3,0 kW/cm² beträgt.

Es besteht in einer besonders vorteilhaften Ausführungsform die Möglichkeit, dass die Pulse des Magnetrons eine Zeitdauer haben, die ≤ 100 µs ist. In einer besonders vorteilhaften Ausführungsform wird vorgeschlagen, dass die Pulse des Magnetrons eine Zeitdauer haben, die ≤ 50 µs, vorzugsweise ≤ 40 µs, insbesondere ≤ 35 µs ist. Es hat sich gezeigt, dass sich möglichst kurze Pulse positiv auf die Eigenschaften der Metalloxidschicht auswirken können.

Die Pulse des Magnetrons können vorteilhaft eine Frequenz aufweisen, die mindestens 100 Hz beträgt. Die Pulse können in einer besonders bevorzugten Ausführungsform eine Frequenz zwischen 350 Hz und 2 kHz aufweisen.

Es kann in einer vorteilhaften Ausführungsform vorgesehen sein, dass für die Erzeugung der transparenten und leitfähigen Metalloxidschicht ein keramisches Target zerstäubt wird. In einer alternativen vorteilhaften Ausführungsform besteht die Möglichkeit, dass für die Erzeugung der transparenten und leitfähigen Metalloxidschicht ein metallisches Target im Reaktivgasprozess unter Zugabe von Sauerstoff zerstäubt wird.

In einer bevorzugten Ausführungsform wird vorgeschlagen, dass die Temperatur, bei der das Substrat mit dem Metalloxid beschichtet wird, kleiner als 100 °C ist. Vorzugsweise wird das Substrat bei Raumtemperatur mit dem Metalloxid beschichtet. Durch die Verwendung des hier vorgestellten hochionisierenden Beschichtungsverfahrens bei Raumtemperatur beziehungsweise bei Temperaturen kleiner 100 °C können gegenüber den bisherigen, mit herkömmlichen PVD- und ionisierenden PVD-Verfahren erzeugten Schichten neuartige und deutlich verbesserte Schichteigenschaften erzielt werden. Diese verbesserten Eigenschaften zeigen sich zum Beispiel in einer höheren mechanischen Stabilität der Metalloxidschicht. Bei den aus dem Stand der Technik bekannten Verfahren wurde bei einer Beschichtung des Substrats bei Raumtemperatur noch eine Vorzugsorientierung der wachsenden Kristallite erhalten. Demgegenüber können mittels des hier vorgestellten Verfahrens feinkristalline Metalloxidschichten auf der Substratoberfläche mit strukturellen Eigenschaften erzeugt werden, die denjenigen eines Metalloxidpulvers entsprechen. Somit eignet sich zum Beispiel ein Glasprodukt, welches ein Glassubstrat, auf dem eine transparente und leitfähige Metalloxidschicht (beispielsweise eine Indiumzinnoxidschicht) nach dem hier beschriebenen Verfahren aufgebracht worden ist, für eine Außenverglasung eines Kraftfahrzeugs oder für andere Anwendungen, bei denen die Beschichtung einer hohen mechanischen und/oder chemischen Belastung ausgesetzt sind.

In einer besonders vorteilhaften Ausführungsform ist vorgesehen, dass die Metalloxidschicht mit einer feinkristallinen Struktur erzeugt wird, deren laterale und vertikale Korngrößen kleiner als 35 nm sind.

In einer weiteren vorteilhaften Ausführungsform besteht die Möglichkeit, dass das Substrat mit der darauf aufgebrachten Metalloxidschicht in einem weiteren Verfahrensschritt getempert wird. Der Temperprozess kann insbesondere ESG-/VSG-Temperprozess sein, bei dem Prozesstemperaturen von etwa 650°C erreicht werden können. Vorzugsweise behält die Metalloxidschicht ihre Kristallinität sowie die Kristallitgröße nach dem Temperschritt im Wesentlichen bei. Vorzugsweise ist die Kristallitgrößenänderung nach dem Temperschritt sowohl lateral als auch vertikal kleiner als 30 %, vorzugsweise kleiner als 20 %, insbesondere kleiner als 10 %.

Es hat sich beispielsweise gezeigt, dass eine Indiumzinnoxidschicht mit einer Dicke von 140nm (oder einem Vielfachen dieser Dicke auf Grund von Interferenzerscheinungen), bei der sie eine besonders hohe Transparenz im sichtbaren Spektralbereich (circa 380 nm bis 780 nm) aufweist, nach einem ESG-/VSG-Temperprozess und/oder Biegeprozess eine gute Leitfähigkeit (< 300 µΩcm) bei gleichzeitig hoher Transmission (>75% auf 2 mm Floatglas) und ebenfalls hoher mechanischer und chemischer Stabilität aufweist.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: den zeitlichen Verlauf eines Strom- und Leistungspulses eines induktiv gekoppelten Magnetrons zur Erzeugung von HPPMS-Pulsen, die zur Herstellung einer Metalloxidschicht auf einem Substrat verwendet werden,
- Fig. 2: die Ergebnisse von Verschleißprüfungen unterschiedlicher Proben in Abhängigkeit von den Umdrehungen eines Drehtellers einer Verschleißprüfeinrichtung gemäß DIN 52 347 (1987).

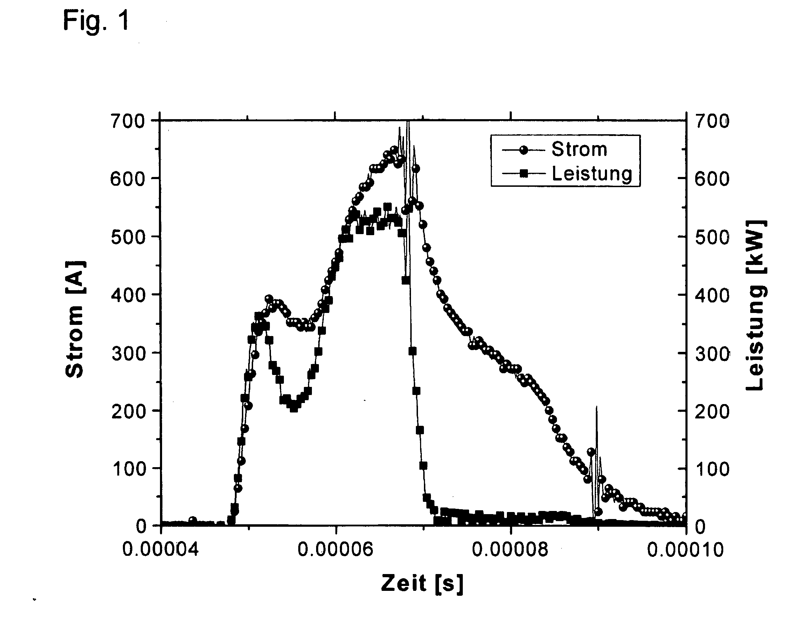

Zunächst wird auf Fig. 1 Bezug genommen, in der ein mögliches Pulsmuster eines induktiv gekoppelten Systems zur Erzeugung von Hochleistungspuls-Magnetronsputter-Pulsen (kurz: HPPMS-Pulsen), die zur Herstellung einer transparenten und leitfähigen Metalloxidschicht auf einem Substrat verwendet werden, dargestellt ist. Die hier gezeigten Pulsmuster werden durch die Art des verwendeten Generators bestimmt, der die Einkopplung induktiv vornimmt. Grundsätzlich sind auch andere Strom- beziehungsweise Leistungsverläufe möglich. Von besonderer Wichtigkeit für die Eigenschaften der Metalloxidschicht ist der innerhalb eines begrenzten Zeitraums erzielte Stromanstieg. In dem hier gezeigten Ausführungsbeispiel wurde mit einem herkömmlichen Magnetron mit einem Magnetfeld von 30 mT an der Targetoberfläche gearbeitet. Der Stromanstieg ist dabei abhängig von der Magnetfeldstärke und lässt sich durch eine Erhöhung der Magnetfeldstärke deutlich erhöhen.

Im Vergleich zu herkömmlichen DC-Magnetronsputterverfahren und den bisher verwendeten ionisierenden Verfahren führt das hier vorgestellte Hochleistungs-Magnetronsputterverfahren zu einer erhöhten kinetischen Energie sowie zu einem höheren Ionisationsgrad der zur Schichtbildung beitragenden Elemente, die entscheidend dafür sind, um zum Beispiel in einem sich an die Schichtbildung anschließenden Einscheibensicherheitsglas- oder Verbundsicherheitsglas-Temperschritt eine mechanisch stabile Metalloxidschicht auf einem Glassubstrat zu erhalten.

Das Verfahren zur Herstellung der transparenten und leitfähigen Metalloxidschicht auf dem Substrat zeichnet sich allgemein dadurch aus, dass
- die Pulse des Magnetrons eine Peakleistungsdichte aufweisen, die größer als 1,5 kW/cm² ist,
- die Pulse des Magnetrons eine Zeitdauer haben, die ≤ 200 µs ist, sowie
- der mittlere Stromflussdichteanstieg beim Zünden des Plasmas innerhalb eines Zeitintervall, das ≤ 0.025 ms ist, mindestens 106 A/(ms cm²) beträgt.

Die Substrate, die mit der transparenten und leitfähigen Metalloxidschicht beschichtet werden, können insbesondere aus Glas, Kunststoff, Metall oder Keramik bestehen.

Für die Herstellung der Metalloxidschicht kann beispielsweise ein keramisches Festkörper-Target verwendet werden, das mit Hilfe des Hochleistungs-Magnetronsputterverfahrens zerstäubt wird. Alternativ besteht auch die Möglichkeit, dass für die Herstellung der Metalloxidschicht ein metallisches Festkörper-Target in einem Reaktivgasprozess unter Zugabe von Sauerstoff verwendet wird.

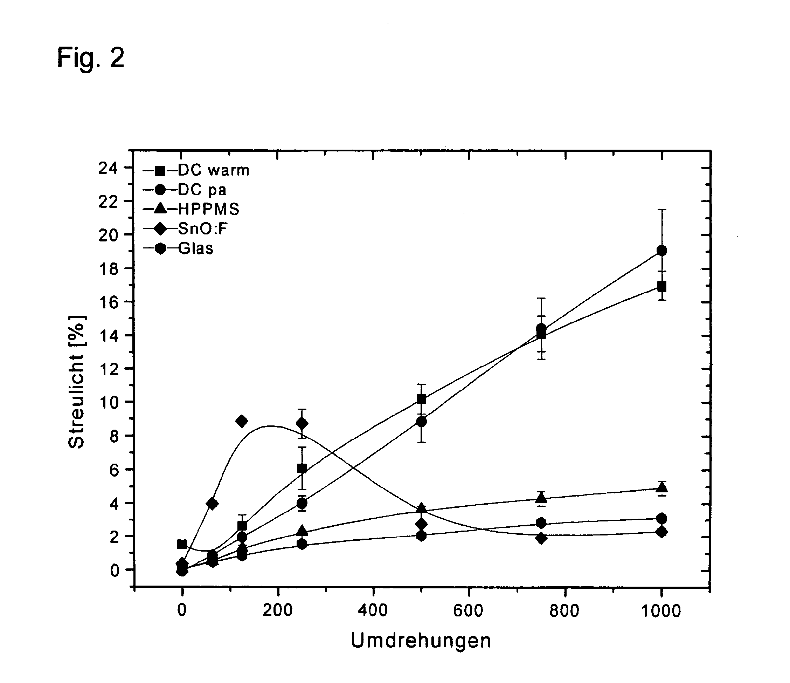

Um die vorteilhaften Eigenschaften der mittels des hier vorgestellten Verfahrens hergestellten transparenten und leitfähigen Metalloxidschichten auf einem Glassubstrat zu veranschaulichen, wird nachfolgend auf Fig. 2 Bezug genommen, in der ein Vergleich der Trübungs-("Haze"-)Messungen verschiedener Proben dargestellt ist.

Die Messergebnisse geben Aufschluss über den Verschleiß der Proben nach einer bestimmten mechanischen Belastung. Die Verschleißprüfungen erfolgten mittels eines Reibradverfahrens mit Streulichtmessung gemäß DIN 52 347 (1987). Dieses Prüfverfahren wird häufig auch als "Taber-Test" bezeichnet. Die Proben werden, wie in der DIN 52 347 (1987) näher erläutert, auf einem Drehteller der -Verschleißprüfeinrichtung durch zwei sich in entgegengesetzter Richtung drehende Reibräder auf Gleitverschleiß beansprucht. Messgröße für den Verschleißgrad der Proben ist der Streulichtanteil des transmittierten Lichts, der durch Oberflächenveränderungen hervorgerufen wird und zu einer Trübung der Proben führt.

In Fig. 2 sind die Ergebnisse von Verschleißuntersuchungen folgender Proben dargestellt:
- herkömmliches Glas,
- ein Glassubstrat mit einer SnO:F-Beschichtung,
- ein Glassubstrat mit einer Indiumzinnoxidschicht, die bei Raumtemperatur mit einem herkömmlichen DC-Sputterverfahren auf das Substrat aufgebracht und anschließend getempert wurde (in Fig. 2 als "DC pa" bezeichnet),
- ein Glassubstrat mit einer Indiumzinnoxidschicht, die bei T=300°C mit einem herkömmlichen DC-Sputterverfahren auf das Substrat aufgebracht wurde (in Fig. 2 als "DC warm" bezeichnet), sowie
- ein Glassubstrat mit einer Indiumzinnoxidschicht, die durch ein Hochleistungs-Magnetronsputterverfahren mit den im Rahmen dieser Anmeldung offenbarten Verfahrensparametern auf das Glassubstrat aufgebracht und anschließend getempert wurde (in Fig. 2 als "HPPMS" bezeichnet).

Aufgetragen ist die integrale Lichtstreuung, die ein Maß für die Trübung der Proben ist, in Abhängigkeit von der Anzahl der Umdrehungen des Drehtellers der Verschleißprüfeinrichtung. Je größer der gemessene prozentuale Streulichtanteil ist, desto höher ist die Trübung der jeweiligen Probe.

Die Ergebnisse zeigen, dass die mit Hilfe des hier vorgestellten Hochleistungs-Magnetronsputterverfahrens hergestellte Metalloxidschicht besonders vorteilhafte mechanische und optische Eigenschaften aufweist.

Die unbeschichtete Glasprobe zeigt mit zunehmender Anzahl der Umdrehungen des Drehtellers der Verschleißprüfeinrichtung einen Anstieg des Streulichtanteils auf etwa 3% (bei 1000 Umdrehungen). Das Glassubstrat mit der SnO:F-Beschichtung zeigt innerhalb der ersten 200 Umdrehungen den höchsten Anstieg des Streulichtanteils auf über 8 % und damit auch die stärkste Trübung in diesem Bereich. Wird die Anzahl der Umdrehungen weiter erhöht, so nähert sich der Streulichtanteil bereits bei 500 Umdrehungen dem Messwert des Streulichtanteils der unbeschichteten Glasprobe an. Zu erklären ist dies mit einem Abrieb der SnO:F-Beschichtung von der Oberfläche des Glassubstrats.

Die beiden mittels des herkömmlichen DC-Sputterverfahrens mit der Indiumzinnoxidschicht beschichteten Glassubstrate zeigen einen mit der Anzahl der Umdrehungen stark ansteigenden Streulichtanteil und damit eine stark erhöhte Trübung. Es fällt auf, dass die Trübung der Probe, die bei T=300°C hergestellt wurde, zunächst stärker ist als die Trübung der bei Raumtemperatur hergestellten Probe. Bei 700 Umdrehungen ist der Streulichtanteil mit etwa 14 % bei beiden Proben nahezu identisch. Bei 1000 Umdrehungen übersteigt der Streulichtanteil des bei Raumtemperatur beschichteten Glassubstrats den Streulichtanteil der bei T=300°C hergestellten Probe. Beide Proben zeigen nach 1000 Umdrehungen einen stark erhöhten Streulichtanteil, der in jedem Fall größer als 16% ist.

Im Vergleich zu den vorstehend genannten Proben zeigt das Glassubstrat, das durch hier beschriebene Hochleistungs-Magnetronsputterverfahren mit einer Indiumzinnoxidschicht beschichtet wurde, erheblich bessere mechanische und optische Eigenschaften, die sich in einem Streulichtanteil zeigen, der zwar mit zunehmender Anzahl der Umdrehungen des Drehtellers der Versuchseinrichtung ansteigt, jedoch selbst bei 1000 Umdrehungen noch kleiner als 5 % ist. Der Streulichtanteil beträgt bei dieser Probe somit weniger als ein Drittel des Streulichtanteils der mittels des herkömmlichen DC-Sputterverfahrens hergestellten Proben.

Zusammenfassend wird deutlich, dass sich die mit Hilfe des hier vorgestellten Verfahrens hergestellten transparenten und leitfähigen Metalloxidschichten im Hinblick auf ihre Stabilität und ihre optischen Eigenschaften in ganz erheblichem Maße von den mit den herkömmlichen Verfahren hergestellten Beschichtungen unterscheiden. Es hat sich beispielsweise gezeigt, dass eine Indiumzinnoxidschicht mit einer Dicke von 140nm, bei der sie eine besonders hohe Transparenz aufweist, nach einem ESG-/VSG-Temperprozess und/oder Biegeprozess eine gute Leitfähigkeit (< 300 µΩcm) bei gleichzeitig hoher Transmission und ebenfalls hoher mechanischer und chemischer Stabilität aufweist. Damit eignet sich ein Glasprodukt, das ein Glassubstrat mit einer derartigen Indiumzinnoxidschicht aufweist, zum Beispiel für die Herstellung einer niedrig emittierenden Außenverglasung eines Kraftfahrzeugs.

## Patentansprüche

1. Verfahren zur Herstellung einer transparenten und leitfähigen Metalloxidschicht auf einem Substrat, bei dem zumindest ein Bestandteil der Metalloxidschicht durch hochionisierendes, gepulstes Hochleistungsmagnetronsputtern zerstäubt wird und auf dem Substrat kondensiert, **dadurch gekennzeichnet, dass**
- die Pulse des Magnetrons eine Peakleistungsdichte aufweisen, die größer als 1,5 kW/cm² ist,
- die Pulse des Magnetrons eine Zeitdauer haben, die ≤ 200 µs ist, sowie
- der mittlere Stromflussdichteanstieg beim Zünden des Plasmas innerhalb eines Zeitintervall, das ≤ 0.025 ms ist, mindestens 106 A/(ms cm²) beträgt.

2. Verfahren nach Anspruch 1, **dadurch gekennzeichnet, dass** die Pulse des Magnetrons eine Peakleistungsdichte aufweisen, die mindestens 3,0 kW/cm² beträgt.

3. Verfahren nach Anspruch 1 oder 2, **dadurch gekennzeichnet, dass** die Pulse des Magnetrons eine Zeitdauer haben, die ≤ 100 µs ist.

4. Verfahren nach einem der Ansprüche 1 bis 3, **dadurch gekennzeichnet, dass** die Pulse des Magnetrons eine Zeitdauer haben, die ≤ 50 µs, vorzugsweise ≤ 40 µs, insbesondere ≤ 35 µs ist.

5. Verfahren nach einem der Ansprüche 1 bis 4, **dadurch gekennzeichnet, dass** die Pulse des Magnetrons eine Frequenz aufweisen, die mindestens 100 Hz beträgt.

6. Verfahren nach einem der Ansprüche 1 bis 5, **dadurch gekennzeichnet, dass** die Pulse des Magnetrons eine Frequenz zwischen 350 Hz und 2 kHz aufweisen.

7. Verfahren nach einem der Ansprüche 1 bis 6, **dadurch gekennzeichnet, dass** für die Erzeugung der Metalloxidschicht ein keramisches Target zerstäubt wird.

8. Verfahren nach einem der Ansprüche 1 bis 6, **dadurch gekennzeichnet, dass** für die Erzeugung der Metalloxidschicht ein metallisches Target in einem Reaktivgasprozess unter Zugabe von Sauerstoff zerstäubt wird.

9. Verfahren nach einem der Ansprüche 1 bis 8, **dadurch gekennzeichnet, dass** die Temperatur, bei der das Substrat mit dem Metalloxid beschichtet wird, kleiner als 100 °C ist.

10. Verfahren nach einem der Ansprüche 1 bis 9, **dadurch gekennzeichnet, dass** die Metalloxidschicht mit einer feinkristallinen Struktur erzeugt wird, deren laterale und vertikale Korngrößen kleiner als 35 nm sind.

11. Verfahren nach einem der Ansprüche 1 bis 10, **dadurch gekennzeichnet, dass** das Substrat mit der Metalloxidschicht in einem weiteren Verfahrensschritt getempert wird.

12. Verfahren nach Anspruch 11, **dadurch gekennzeichnet, dass** die Metalloxidschicht ihre Kristallinität sowie die Kristallitgröße nach dem Temperschritt im Wesentlichen beibehält.

13. Verfahren nach Anspruch 11 oder 12, **dadurch gekennzeichnet, dass** die Kristallitgrößenänderung nach dem Temperschritt sowohl lateral als auch horizontal kleiner als 30 %, vorzugsweise kleiner als 20 %, insbesondere kleiner als 10 % ist.

14. Verfahren nach einem der Ansprüche 1 bis 13, **dadurch gekennzeichnet, dass** das Magnetron ohne BogenentladungsHandling betrieben wird.

## Claims

1. Method for producing a transparent and conductive metal oxide layer on a substrate in which at least one component of the metal oxide layer is atomized by highly ionized pulsed high-power magnetron sputtering and condenses on the substrate, **characterized in that**
- the pulses of the magnetron have a peak power density that is greater than 1.5 kW/cm²,
- the pulses of the magnetron have a duration that is ≤ 200 µs, and
- the average increase in current density during ignition of the plasma within a time interval which is ≤ 0.025 ms is at least 106 A/(ms cm²).

2. Method according to Claim 1, **characterized in that** the pulses of the magnetron have a peak power density that is at least 3.0 kW/cm².

3. Method according to Claim 1 or 2, **characterized in that** the pulses of the magnetron have a duration that is ≤ 100 µs.

4. Method according to one of Claims 1 to 3, **characterized in that** the pulses of the magnetron have a duration that is ≤ 50 µs, preferably ≤ 40 µs, in particular ≤ 35 µs.

5. Method according to one of Claims 1 to 4, **characterized in that** the pulses of the magnetron have a frequency that is at least 100 Hz.

6. Method according to one of Claims 1 to 5, **characterized in that** the pulses of the magnetron have a frequency between 350 Hz and 2 kHz.

7. Method according to one of Claims 1 to 6, **characterized in that** a ceramic target is atomized for the creation of the metal oxide layer.

8. Method according to one of Claims 1 to 6, **characterized in that** a metallic target is atomized in a reactive gas process with the addition of oxygen for the creation of the metal oxide layer.

9. Method according to one of Claims 1 to 8, **characterized in that** the temperature at which the substrate is coated with the metal oxide is less than 100°C.

10. Method according to one of Claims 1 to 9, **characterized in that** the metal oxide layer is created with a finely crystalline structure of which the lateral and vertical grain sizes are less than 35 nm.

11. Method according to one of Claims 1 to 10, **characterized in that** the substrate with the metal oxide layer is tempered in a further method step.

12. Method according to Claim 11, **characterized in that** the metal oxide layer substantially retains its crystallinity and the crystallite size after the tempering step.

13. Method according to Claim 11 or 12, **characterized in that** the change in crystallite size after the tempering step both laterally and horizontally is less than 30%, preferably less than 20%, in particular less than 10%.

14. Method according to one of Claims 1 to 13, **characterized in that** the magnetron is operated without arc discharge handling.

## Revendications

1. Procédé pour produire une couche d'oxyde métallique transparente et conductrice sur un substrat, dans lequel on pulvérise au moins un composant de la couche d'oxyde métallique par pulvérisation magnétron pulsée hautement ionisante et on le condense sur le substrat,
**caractérisé en ce que**
- les impulsions du magnétron présentent une densité de puissance de pic qui est supérieure à 1,5 kW/cm²,
- les impulsions du magnétron présentent une durée temporelle, qui est ≤ 200 µs, ainsi que
- la croissance moyenne de la densité de flux de courant lors de l'allumage du plasma vaut au moins 106 A/(ms cm²) à l'intérieur d'un intervalle de temps, qui est ≤ 0,025 ms.

2. Procédé selon la revendication 1, **caractérisé en ce que** les impulsions du magnétron présentent une densité de puissance de pic, qui vaut au moins 3,0 kW/cm².

3. Procédé selon la revendication 1 ou 2, **caractérisé en ce que** les impulsions du magnétron présentent une durée temporelle, qui est ≤ 100 µs.

4. Procédé selon l'une quelconque des revendications 1 à 3, **caractérisé en ce que** les impulsions du magnétron présentent une durée temporelle, qui est ≤ 50 µs, de référence ≤ 40 µs, en particulier ≤ 35 µs.

5. Procédé selon l'une quelconque des revendications 1 à 4, **caractérisé en ce que** les impulsions du magnétron présentent une fréquence, qui vaut au moins 100 Hz.

6. Procédé selon l'une quelconque des revendications 1 à 5, **caractérisé en ce que** les impulsions du magnétron présentent une fréquence comprise entre 350 Hz et 2 kHz.

7. Procédé selon l'une quelconque des revendications 1 à 6, **caractérisé en ce que** l'on pulvérise une cible céramique pour produire la couche d'oxyde métallique.

8. Procédé selon l'une quelconque des revendications 1 à 6, **caractérisé en ce que** l'on pulvérise une cible métallique dans un processus de gaz réactif avec addition d'oxygène pour produire la couche d'oxyde métallique.

9. Procédé selon l'une quelconque des revendications 1 à 8, **caractérisé en ce que** la température, à laquelle le substrat est revêtu avec l'oxyde métallique, est inférieure à 100°C.

10. Procédé selon l'une quelconque des revendications 1 à 9, **caractérisé en ce que** l'on produit la couche d'oxyde métallique avec une structure cristalline fine, dont les tailles de grain latérale et verticale sont inférieures à 35 nm.

11. Procédé selon l'une quelconque des revendications 1 à 10, **caractérisé en ce que** l'on équilibre la température du substrat avec la couche d'oxyde métallique dans une étape supplémentaire du procédé.

12. Procédé selon la revendication 11, **caractérisé en ce que** la couche d'oxyde métallique conserve essentiellement sa cristallinité ainsi que la taille des cristallites après l'étape d'équilibrage de la température.

13. Procédé selon la revendication 11 ou 12, **caractérisé en ce que** la variation de taille des cristallites après l'étape d'équilibrage de la température, aussi bien latéralement qu'horizontalement, est inférieure à 30 %, de préférence inférieure à 20 %, en particulier inférieure à 10 %.

14. Procédé selon l'une quelconque des revendications 1 à 13, **caractérisé en ce que** l'on utilise le magnétron sans opération de décharge en arc.
